# EUROPEAN PATENT SPECIFICATION

(11) **EP 0 986 786 B1**
(45) Date of publication and mention of the grant of the patent: **05.12.2001**
(21) Application number: 98930790.5
(22) Date of filing: 29.05.1998
(51) Int. Cl.: G06F 11/20

(54) **DEVICE FOR SAVING THE CONFIGURATION OF A REDUNDANT SYSTEM**
VORRICHTUNG ZUM SICHERN DER KONFIGURATION EINES REDUNDANTEN SYSTEMS
DISPOSITIF DE SAUVEGARDE DE LA CONFIGURATION D'UN SYSTEME REDONDANT

(30) Priority: 02.06.1997 FR 9707001
(43) Date of publication of application: 22.03.2000
(73) Proprietor: TRT Lucent Technologies (SA), 92359 Le Plessis Robinson (FR)
(72) Inventor: CLOZEAU, Olivier, F-91310 Leuville Sur Orge (FR)
(74) Representative: Williams, David John
(86) International application number: EP9803436
(87) International publication number: WO9855924

(56) References cited:
- EP-A- 0 455 922
- WO-A-90/07827
- "FAULT ISOLATION AND RECONFIGURATION IN A COMMUNICATON CONTROLLER WITH DISTRIBUTED PROCESSING" IBM TECHNICAL DISCLOSURE BULLETIN, vol. 38, no. 10, 1 October 1995, pages 457-460, XP000540558

## Description

The present invention relates to a device for saving the configuration of a system comprising two identical redundant units and a switching unit which is intended to operate one or other of the redundant units selectively. The invention finds its application most especially in the construction of radio relay transmission equipment.

Figuring among the essential qualities which may be expected of transmission equipment are of course its resistance to various disturbances and its capacity to transmit data error-free which are of major importance, and also its behaviour in the event of a breakdown. For this purpose it is customary to double up all or part of the equipment, so as to minimize interruptions to service. Thus, an item of equipment is conventionally seen to have two identical redundant units having the same function, one of these units being selected for operation by a switching unit. To guard against a possible fault in the power supply of the circuit, the supply devices are likewise doubled up. Thus, each redundant unit comprises a power supply device. The switching unit is generally powered in redundancy mode by these supply devices. To simplify the maintenance operations on a faulty unit, a device for saving the configuration of the system units is generally provided. During installation thereof, the system is tailored to the requirements of the customer and the resulting configuration is saved in the device provided for this purpose. In the event of a breakdown and exchange of all or part of the unit, the configuration saved in the device is read back after replacing the faulty unit.

A known saving device consists of a non-volatile memory in which the configuration parameters of the units will be stored. This memory is connected to the various units of the system by means of a bus, of the I2C type for example. It is generally powered by the backup power supply of the switching unit so as to guard against a failure of one of the power supplies of the redundant units. The configuration parameters of each of the units are saved at distinct locations of the memory.

This type of saving device has a major drawback. In the event of a failure of one of the redundant units, there is a risk of autopowering of the faulty unit by the bus wires reserved for data, for addresses and for commands. This may pose a number of problems since, on the one hand, the faulty unit is then powered in a spurious manner and, on the other hand, the power supply which remains on is not designed to power both redundant units at the same time. Consequently, this autopowering of the faulty unit may damage the single in-service power supply as well as the redundant in-service unit which is then no longer adequately powered. Hence, there is a risk of the entire equipment breaking down.

An objective of the invention is to propose a system enabling this drawback to be overcome.

To implement such a system, there is provision to use a saving device comprising three memories powered separately by the unit to which they are linked.

Additionally, the subject of the invention is a device for saving the configuration of a system comprising two identical redundant units and a switching unit which is intended to operate one or other of the redundant units selectively, characterized in that it comprises three memories each for saving the configuration of a unit, which memories are powered separately by the unit to which they are linked.

Preferably, the three configuration memories are placed on a single support intended to be inserted into the switching unit. In a particular embodiment, the support can be removably inserted into the switching unit.

Other characteristics and advantages of the invention will emerge on reading the detailed description which follows and which is given with reference to the single appended figure which represents a system comprising the saving device according to the invention.

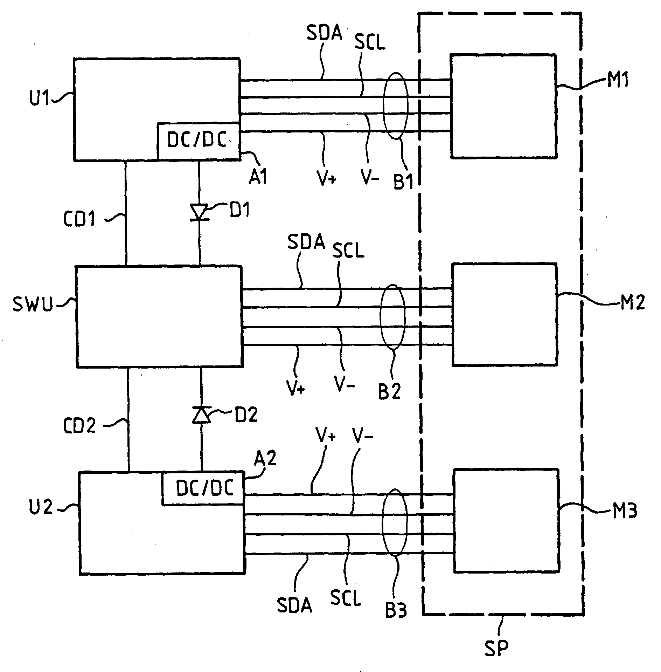

The transmission system illustrated in the single figure consists of two units U1 and U2 having the same function and of a switching unit SWU. The redundant units U1 and U2 are fitted with two power supply devices, A1 and A2 respectively, which in practice are energy converters. The switching unit SWU is designed to operate one or other of the units U1, U2 selectively. The redundant units are selected by way of connection wires CD1 and CD2 which convey the turn-on command to one or other of the units U1 or U2. The unit SWU is powered in redundancy mode by the power supply devices A1 and A2 of the units U1 and U2. To this end, the system comprises two diodes D1 and D2 for connecting the power supply devices, A1 and A2 respectively, to the switching unit.

According to the invention, the system comprises a device for saving the configuration of the units U1, U2 and SWU consisting of three non-volatile memories M1, M2 and M3 mounted on a support SP. Each memory is intended to save the configuration parameters of a unit. When it is first put into service, the system is configured and then the configuration of its units is saved automatically in the memories of the saving device. This automatic save is performed by software provided for this purpose. The configuration parameters of a unit are conveyed to the corresponding memory by means of a bus which connects this memory alone to this unit. The system therefore has three distinct and independent buses B1, B2, B3. In the example of the single figure, the buses employed are of the I2C type and therefore include a wire SDA for the data, addresses and commands, a wire SCL for the clock signal and two power supply wires V+ and V-.

The three memories M1, M2 and M3 are completely independent, especially from the standpoint of their power supply, this making it possible to guard against the risk of the autopowering of a unit which is off. Moreover, such a system makes it possible to use very simple saving software individual to each unit. It will be possible to store the configuration parameters of the units at the same addresses but in different memories. The software is the same for each unit, thereby ensuring perfect compatibility of the units irrespective of the type of equipment.

The saving device of the invention preferably takes the form of a card which is inserted into the switching unit. During a maintenance operation on one of the redundant units U1 or U2, the operator cuts the power supply of the failed unit, replaces it by an equivalent unit which is working perfectly and switches the latter on. The configuration saved in the corresponding memory is then automatically read back and the new unit is configured without any particular intervention by the operator.

If a maintenance operation is performed on the switching unit, the operator removes the configuration card from the failed switching unit and simply inserts it into the replacement switching unit.

## Claims

1. Device for saving the configuration of a system comprising two identical redundant units (U1, U2) and a switching unit (SWU) which is intended to operate one or other of the redundant units (U1, U2) selectively,
**characterized in that** it comprises three memories (M1, M2, M3) each for saving the configuration of a unit, which memories are powered separately by the unit to which they are linked.

2. Saving device according to Claim 1, **characterized in that** the switching unit (SWU) is powered in redundancy mode by the power supplies (A1, A2) of the two redundant units (U1, U2).

3. Saving device according to Claim 1 or 2, **characterized in that** the three configuration memories (M1, M2, M3) are placed on a single support (SP) intended to be inserted into the switching unit (SWU).

4. Saving device according to Claim 3, **characterized in that** the said support (SP) can be removably inserted into the switching unit (SWU).

## Patentansprüche

1. Einrichtung zum Sichern der Konfiguration eines Systems, das zweite identische redundante Einheiten (U1, U2) und eine Schalteinheit (SWU) umfaßt, die die eine oder die andere der redundanten Einheiten (U1, U2) gezielt betreiben soll,
**dadurch gekennzeichnet, daß** sie drei Speicher (M1, M2, M3) jeweils zum Sichern der Konfiguration einer Einheit umfaßt, wobei die Speicher durch die Einheit, an die sie angeschlossen sind, getrennt bestromt werden.

2. Sicherungseinrichtung nach Anspruch 1, **dadurch gekennzeichnet, daß** die Schalteinheit (SWU) durch die Stromversorgungen (A1, A2) der beiden redundanten Einheiten (U1, U2) im Redundanzmodus bestromt wird.

3. Sicherungseinrichtung nach Anspruch 1 oder 2, **dadurch gekennzeichnet, daß** die drei Konfigurationsspeicher (M1, M2, M3) auf einem einzelnen Träger (SP) angeordnet sind, der in die Schalteinheit (SWU) eingeführt werden soll.

4. Sicherungseinheit nach Anspruch 3, **dadurch gekennzeichnet, daß** der Träger (SP) entfernbar in die Schalteinheit (SWU) eingeführt werden kann.

## Revendications

1. Dispositif de sauvegarde de la configuration d'un système comprenant deux unités redondantes identiques (U1, U2) et une unité de commutation (SWU) destinée à actionner l'une ou l'autre des unités redondantes (U1, U2) de façon sélective,
**caractérisé en ce qu'**il comprend trois mémoires (M1, M2, M3), chacune pour sauvegarder la configuration d'une unité, lesquelles mémoires sont alimentées séparément par l'unité à laquelle elles sont reliées.

2. Dispositif de sauvegarde selon la revendication 1, **caractérisé en ce que** l'unité de commutation (SWU) est alimenté en mode de redondance par les alimentations (A1, A2) des deux unités redondantes (U1, U2)

3. Dispositif de sauvegarde selon la revendication 1 ou 2, **caractérisé en ce que** les trois mémoires de configurations (M1, M2, M3) sont placées sur un support unique (SP) destiné à être inséré sans l'unité de commutation (SWU).

4. Dispositif de sauvegarde selon la revendication 3, **caractérisé en ce que** ledit support (SP) peut être inséré de manière amovible dans l'unité de commutation (SWU).
